(19) Europäisches Patentamt
European Patent Office
Office européen des brevets

(11) EP 0 895 092 B1

(12) **EUROPÄISCHE PATENTSCHRIFT**

(45) Veröffentlichungstag und Bekanntmachung des Hinweises auf die Patenterteilung:
**11.10.2000 Patentblatt 2000/41**

(51) Int Cl.$^7$: **G01R 33/34**

(21) Anmeldenummer: **98113745.8**

(22) Anmeldetag: **23.07.1998**

(54) **Supraleitender Hybrid-Resonator für dem Empfang von NMR-Signalen**

Superconducting hybrid-resonator for the reception of NMR signals

Résonateur hybride supraconducteur pour la réception de signaux RMN

(84) Benannte Vertragsstaaten:
**CH DE FR GB LI**

(30) Priorität: **02.08.1997 DE 19733574**

(43) Veröffentlichungstag der Anmeldung:
**03.02.1999 Patentblatt 1999/05**

(73) Patentinhaber: **Bruker AG**
**8117 Fällanden (CH)**

(72) Erfinder: **Marek, Daniel, Dr.nat.sci.**
**5103 Möriken (CH)**

(74) Vertreter: **KOHLER SCHMID + PARTNER**
**Patentanwälte**
**Ruppmannstrasse 27**
**70565 Stuttgart (DE)**

(56) Entgegenhaltungen:
**EP-A- 0 738 897    DE-A- 4 218 635**

EP 0 895 092 B1

**Beschreibung**

Die Erfindung betrifft einen Hochfrequenz (HF)-Resonator zum resonanten Aussenden und/oder Empfangen von HF-Signalen auf einer gewünschten Resonanzfrequenz in eine bzw. aus einer Meßprobe in einem Untersuchungsvolumen im homogenen Magnetfeld $B_0$ einer Kernspinresonanz(NMR)-Apparatur, wobei der HF-Resonator supraleitende Komponenten umfaßt.

Ein solcher Hochfrequenz-Resonator ist an sich bekannt aus der US 5,585,723.

Eine der wichtigsten Forderungen in der NMR-Spektroskopie ist die Erreichung einer hohen Signalempfindlichkeit, d.h. eines hohen Signal-zu-Rausch-Verhältnisses (=S/N-Verhältnis) des NMR-Signals.

Die Grösse S des Signals ist hauptsächlich vom geometrischen Aufbau des Resonators abhängig und davon, wie eng dieser die Messprobe umgibt. Die Temperatur des Resonators spielt dabei eine untergeordnete Rolle.

Die Rauschspannung des Resonators hingegen ist stark von der Temperatur abhängig. Der Resonator ist aus induktiven und kapazitiven Anteilen zusammengesetzt, die auf der gewünschten Frequenz in Resonanz sind. Die Rauschspannung N wird im HF-Verlustwiderstand $R_V$ des Resonators erzeugt und setzt sich aus dem Rauschen im kapazitiven Anteil des Resonators, das allerdings sehr klein ist und praktisch vernachlässigt werden kann, und aus dem dominierenden Rauschen im induktiven Anteil, zusammen. Es ist somit dieser letztere Rauschanteil, der für das Rauschen des Resonators massgebend ist, und dieser Anteil ist sowohl von der Temperatur T wie auch vom temperaturabhängigen HF-Verlustwiderstand $R_V$ (T) abhängig:

$$N \propto \sqrt{T \cdot R_V(T)}$$

Die Temperaturabhängigkeit des S/N-Verhältnisses zeigt sich in folgender Gleichung:

$$S/N \propto \frac{S}{\sqrt{T \cdot R_V(T)}}$$

Durch eine Erniedrigung der Temperatur T des Resonators wird eine Erhöhung des S/N-Verhältnisses erreicht, und zwar dank zweier Effekte: erstens wegen der tieferen Temperatur T im Nenner des obigen Ausdrucks, und zweitens durch den Verlustwiderstand $R_V$ (T), der bei tieferen Temperaturen ebenfalls kleiner wird.

Es ist deshalb vorteilhaft, den Resonator auf sehr tiefe Temperaturen abzukühlen, z.B. auf Temperaturen im Bereich von 4K bis 20K. Wählt man für den Aufbau des induktiven Anteils des Resonators supraleitendes Material, so erreicht man besonders gute Resultate, denn bei einem Supraleiter ist der HF-Verlustwiderstand $R_V$(T) wesentlich niedriger als bei einem normal leitenden Metall wie Kupfer. Dadurch kann das S/N-Verhältnis gemäss obiger Gleichung sehr hohe Werte erreichen.

Die NMR-Spektroskopie benützt heute Messmethoden, die fast ausschliesslich HF-Impulse zur Anregung des magnetischen Spinsystems und eine anschliessende Fourier-Transformation verwenden. Die Anregung erfolgt normalerweise über den gleichen Resonator, mit dem das NMR-Signal anschliessend detektiert wird. Es ist deshalb wichtig, dass nach erfolgtem HF-Impuls der Resonator möglichst schnell wieder stromfrei ist, um das NMR-Signal optimal empfangen zu können.

Nun ist es aber so, dass Resonatoren mit sehr geringen lusten sehr schmale Resonanzlinien und damit auch sehr lange Abklingzeiten des Anregungsimpulses besitzen. Damit der Resonanzstrom z.B. auf 1% seines Anfangswertes abgeklungen ist, muss eine bestimmte Zeit $t_{1\%}$ abgewartet werden:

$$t_{1\%} \approx 9,21 \cdot L/R(T)$$

wobei L die Induktivität des Resonators ist.

Diese Gleichung zeigt deutlich, dass je kleiner der Verlustwiderstand R(T) des Resonators ist, desto länger werden die Abklingzeiten.

Um die modernen Messmethoden anwenden zu können, werden heute sehr kurze HF-Anregungsimpulse (=harte Impulse) benötigt, die in der Grössenordnung von 10 µs und darunter liegen können. Beachtet man zudem, dass das Produkt von Pulsdauer des Anregungsimpulses mal Feldamplitude am Ort der Messprobe einen definierten optimalen Wert besitzen muss, so führt dies bei solch kurzen Anregungsimpulsen zu sehr hohen Feldamplituden und deshalb sehr hohen elektrischen HF-Strömen im Resonator. Diese müssen zuerst genügend stark abgeklungen sein, bevor auf Empfang geschaltet werden kann. Der verzögerte Empfang hat aber leider zur Folge, dass krumme Basislinien und verzerrte Spektrallinien im NMR-Spektrum entstehen. Bei supraleitenden Resonatoren kann es deshalb vorteilhaft sein, wenn zusätzliche Verlustwiderstände vorhanden sind, welche die Abklingzeit des Anregungsimpulses reduzieren. Diese Verlustwiderstände dürfen jedoch nicht zu gross sein, da sonst das S/N-Verhältnis zu stark verschlechtert wird. Deshalb kommt diese Methode nur dann in Frage, wenn das S/N-Verhältnis bereits auf sehr hohe Werte getrimmt wurde, z.B. durch Verwendung einer geeigneten Geometrie des Resonators, die einen besonders hohen Füllfaktor liefert.

Da der Bau von supraleitenden NMR-Resonatoren eine neue Entwicklungsrichtung in der NMR ist, liegen nicht viele Veröffentlichungen vor. Die eingangs zitierte US 5,585,723 stellt den gegenwärtigen Stand der Technik dar. Der supraleitende Resonator (siehe Fig. 16a und b) wird als vollständiges Resonanzsystem, d.h. sowohl mit seinen induktiven wie auch kapazitiven Anteilen, auf einem ebenen Kristallplättchen 18a angebracht, das auf einer Seite mit einem supraleitenden Material 19a beschichtet und nahe an der Messprobe 5 befestigt ist.

Die Abmessungen des Resonators müssen in diesem Fall gross im Vergleich zum Durchmesser der Messprobe sein, damit das erzeugte HF-Feld genügend homogen im Bereich der Messprobe ist. Eine Verbesserung in dieser Hinsicht erreicht man durch die Kombination von zwei identischen Resonatoren 19a und 19b, die als Helmholtz-Resonatorpaar links und rechts der Messprobe 5 angeordnet sind. Dadurch erreicht man nicht nur ein homogeneres HF-Feld, sondern auch eine stärkere Ankopplung an die Messprobe, d.h. einen besseren Füllfaktor.

Eine solche Helmholtz-Resonatoranordnung stellt ein schwingfähiges Gebilde dar, das zwei ausgeprägte Eigenresonanzen besitzt, nämlich eine obere, bei der die Ströme in den beiden Resonatoren entgegengesetzt gerichtet sind, und eine untere, bei der die Ströme gleich gerichtet sind. Für NMR-Anwendungen muss die untere Eigenresonanz verwendet werden, denn nur diese erzeugt das gewünschte homogene HF-Feld am Ort der Messprobe. Die Resonatoren werden normalerweise induktiv angekoppelt, um das NMR-Signal in das Empfangssystem des NMR-Spektrometers weiterzuleiten.

Als supraleitendes Material werden heute Hochtemperatursupraleiter (HT-Supraleiter) verwendet wie z.B. YBCO, denn ihre elektrischen Eigenschaften zeigen eine sehr geringe Abhängigkeit vom statischen Magnetfeld $B_0$. Diese HT-Supraleiter werden im allgemeinen als dünne Schichten auf einem Kristallplättchen aufgetragen, damit die Kristallkörner, aus denen diese Supraleiter bestehen, alle gleich orientiert sind. Nur so erreicht der HT-Supraleiter die besten elektrischen Eigenschaften. Die Oberfläche des Kristallplättchens hat die Funktion einer Vorlage, auf der die kristalline, supraleitende Schicht angebracht und gezwungen wird, die Orientierung des Kristallplättchens zu übernehmen. Es ist deshalb günstig, wenn nicht irgend ein Kristallplättchen verwendet wird, sondern nur eines, dessen Kristallstruktur der des Supraleiters möglichst nahe kommt. Wenn diese Plättchen als Dielektrikum für die kapazitiven Anteile des Resonators benützt werden, sollten sie auch gute dielektrische HF-Eigenschaften besitzen. Alle diese Anforderungen werden z.B. durch die beiden Kristalle $LaAlO_3$ und Saphir erfüllt. Es kann auch vorteilhaft sein, wenn diese Plättchen thermisch gut leiten, um eine bessere Kühlung der supraleitenden Beschichtung zu gewährleisten. Saphir erfüllt auch diese Bedingung.

Die Verwendung von HT-Supraleitern hat noch einen weiteren Vorteil. Wegen ihrer hohen kritischen Temperaturen, die in der Gegend von 100 K liegen, steht ein grosser Temperaturbereich zur Verfügung, in welchem die guten supraleitenden HF-Eigenschaften des Resonators noch wirksam sind. Dies erlaubt eine höhere Flexibilität bei der Einstellung der Betriebstemperatur.

Die Kristallplättchen stehen heute nur in Form von ebenen Plättchen zur Verfügung, und deshalb wird der Resonator ebenfalls als ebene Struktur ausgelegt. Mit einem gekühlten Heliumgasstrom, dessen Temperatur unterhalb 20 K liegt, wird das Plättchen auf kryogene Temperaturen gekühlt.

Die geometrische Anordnung der Resonatoren gemäss dem heutigen Stand der Technik haben mehrere schwerwiegende Nachteile, die nachfolgend erläutert werden sollen:

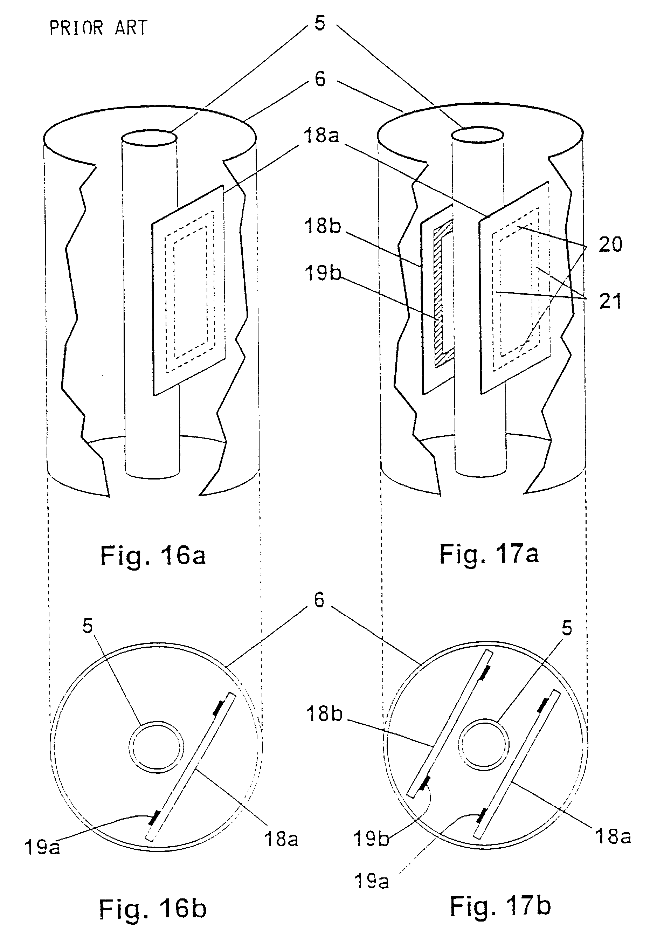

Die Resonatoranordnungen setzen sich aus einem oder zwei einzelnen Resonatoren zusammen, die auf einem oder zwei Kristallplättchen aufgebaut sind, wobei jeder einzelne Resonator ein vollständiges Resonanzsystem darstellt. Nehmen wir die optimalere Anordnung an, nämlich ein Helmholtz-Resonatorpaar (siehe Fig. 17a/b), dann wird man dieses Helmholtzpaar so eng wie möglich um die Messprobe anordnen, damit ein möglichst hoher Füllfaktor erreicht wird. Da jedoch das Helmholtzpaar aus zwei ebenen Strukturen besteht, die schlecht an die Zylindergeometrie der Messprobe angepasst sind, erreicht man trotzdem keinen grossen Füllfaktor. Man erkennt dies an den Eckbereichen der beiden Resonatoren, die relativ weit von der Probe entfernt sind. Einzig die horizontalen Querverbindungen 20 kommen nahe an der Probe vorbei und sind stärker an die Messprobe gekoppelt.

Die horizontalen Querverbindungen 20 haben einen weiteren, sehr gravierenden Nachteil. Sie liegen nämlich nicht parallel zum $B_0$-Feld sondern senkrecht zu diesem, und das sollte wenn immer möglich vermieden werden, weil dadurch die Homogenität des $B_0$-Feldes verschlechtert wird. Um diese Verschlechterung in Grenzen zu halten, muss der Supraleiter sehr schmal, d.h. mit möglichst wenig Material realisiert werden. Dadurch sinkt aber der maximal erlaubte HF-Strom, unterhalb dem noch ein linearer Zusammenhang zwischen HF-Strom und HF-Feld besteht, und damit auch das maximal erlaubte HF-Feld. Um einen bestimmten NMR-Flipwinkel zu realisieren, müssen deshalb längere Pulszeiten in Kauf genommen werden, was bei vielen NMR-Experimenten zu unschönen Spektren führt.

Ein weiterer Nachteil rührt von den vertikalen Längsverbindungen 21 des Resonators her, die aus Platzgründen sehr nahe an einer HF-Abschirmung 6 liegen. Diese erzeugen dort Wirbelströme und damit HF-Verluste, die sich zurück in den Resonator transformieren. Dadurch werden zwar die Abklingzeiten des Anregungsimpulses verkleinert, was vorteilhaft ist, zugleich aber auch das S/N-Verhältnis verschlechtert. Da jedoch der Füllfaktor einer solchen Helmholtzanordnung bereits schlecht ist, macht sich hier der negative Einfluss der HF-Verluste auf das S/N-Verhältnis besonders stark bemerkbar.

Aufgabe der vorliegenden Erfindung ist es demgegenüber, einen HF-Resonator mit den eingangs beschriebenen Merkmalen für NMR-Anwendungen vorzustellen, der trotz der Verwendung von supraleitenden Materialien einen erheblich höheren Füllfaktor ermöglicht, bei dem die Homogenität des $B_0$-Feldes nicht verschlechtert wird und das erreichbare S/N-Verhältnis besonders hoch ist.

Erfindungsgemäß wird diese Aufgabe dadurch gelöst, dass der HF-Resonator mindestens zwei, räumlich voneinander getrennte, im Betriebszustand supraleitende Komponenten aufweist, die weder einzeln für sich genommen noch zusammen ein geschlossenes Resonanzsystem bilden, das auf der gewünschten Resonanzfrequenz resonant schwingen kann, daß im Betriebszustand normal-leitende Verbindungselemente vorgesehen sind, die die supraleitenden Komponenten galvanisch oder kapazitiv derart miteinander verbinden, daß die supraleitenden Komponenten zusammen mit den normal-leitenden Verbindungselementen und zusätzlichen Mitteln zum Einstellen der Resonanzfrequenz ein oder mehrere geschlossene, auf der gewünschten Resonanzfrequenz resonant schwingungsfähige Resonanzsysteme bilden, und daß die supraleitenden Komponenten und die mit ihnen galvanisch oder kapazitiv verbundenen Verbindungselemente einen sogenannten "Bird-Cage"- Resonator mit Punktsymmetrie oder Axialsymmetrie bilden, wobei die supraleitenden Komponenten die axialen Leiterteile und die normal-leitenden Verbindungselemente die ringförmigen Leiterteile der "Bird-Cage"-Struktur bilden.

Aus der DE 42 18 635 A1 ist eine Hochfrequenz-Empfangsantenne einer Einrichtung zur Kernspintomographie mit mindestens einem Kondensator bekannt, der eine Schichtstruktur aus einem metalloxidischen Supraleitermaterial mit hoher Sprungtemperatur aufweisen soll.

In der US-A 5,258,710 ist ein sogenannter "Birdcage"-Resonator beschrieben, der aus einer Vielzahl feiner Streifen eines supraleitenden Materials, beispielsweise YBCO aufgebaut ist. Verbindungselemente aus normal-leitendem Material sind hier aber nicht vorgesehen.

Bei den erfindungsgemässen Resonatoren handelt es sich durchwegs um solche, die mit normal-leitendem und supraleitendem Material aufgebaut sind. Als Supraleiter wird vorwiegend ein Hochtemperatursupraleiter wie z.B. YBCO verwendet.

Die erfindungsgemäße Lehre basiert auf folgenden Grundgedanken:

1.) Der HF-Resonator ist aus mindestens zwei supraleitenden Komponenten zusammengesetzt, die im Bereich der gewünschten Frequenz und einzeln betrachtet keine strommässig geschlossenen Resonanzsysteme darstellen, über normal leitende Verbindungselemente galvanisch oder kapazitiv miteinander verbunden sind und erst dadurch ein in sich geschlossenes Resonanzsystem darstellen, das auf der gewünschten Frequenz in Resonanz ist.

Vorzugsweise wird aus den supraleitenden Komponenten und den normal-leitenden Verbindungselementen ein einziges Resonanzsystem gebildet. Es können aber auch mehrere geschlossene Resonanzsysteme gebildet werden, die dann allerdings im Betriebszustand miteinander koppeln. In diesem Fall müßten die einzelnen Resonanzsysteme so abgestimmt sein, daß sie nur ungefähr auf der gewünschten Frequenz in Resonanz sind und sich aus der Kopplung und sich daraus ergebenden Schwebungsfrequenzen die eigentliche gewünschte Resonanzfrequenz ergibt.

2.) Die supraleitenden Komponenten bestehen aus länglichen, schmalen Plättchen, die alle parallel zum $B_0$-Feld orientiert und auf der Oberfläche eines fiktiven Zylinders verteilt sind, dessen Achse parallel zum $B_0$-Feld liegt und mit der Achse der Messprobe übereinstimmt.

Dadurch ergibt sich eine kompakte und eng um die Messprobe liegende geometrische Anordnung des Resonators. Man erreicht einen grösseren Füllfaktor (und damit eine höhere Empfindlichkeit) und mehr freien Raum, um z.B. Gradientenspulen für spezielle NMR-Experimente einzubauen. Zudem liegen alle supraleitenden Beschichtungen parallel zum $B_0$-Feld, und deshalb darf die Breite der Beschichtung viel grösser gewählt werden, ohne dass dadurch die Homogenität des $B_0$-Feldes zu stark verschlechtert wird. Mit breiteren Beschichtungen lassen sich aber grössere HF-Ströme, damit grössere HF-Felder und mithin kürzere HF-Pulse erreichen.

3.) Die normal-leitenden Verbindungselemente bestehen aus zwei zylindrischen Ringen hoher elektrischer Leitfähigkeit und sind am oberen und unteren Ende der supraleitenden Komponenten angebracht.

Durch die Einführung von normal-leitenden Elementen werden HF-Verluste eingeführt, und das hat kürzere Abklingzeiten zur Folge. Der damit verbundene Verlust an Empfindlichkeit wird durch den hohen Füllfaktor wieder wettgemacht, und zwar ohne dass dies mit einer schlechten $B_0$-Homogenität erkauft wird.

4.) Die supraleitenden Komponenten und die mit ihnen galvanisch oder kapazitiv verbundenen Verbindungselemente bilden einen sogenannten "Bird-Cage" Resonator.

Der "Bird-Cage"-Resonator ist zwar als geometrische Anordnung an sich bekannt, wird hier aber zum ersten Mal unter Benützung von normal- und supraleitenden Teilen realisiert. Bis heute fehlte das Know-How, um "Bird-Cage"-Resonatoren mit supraleitenden Elementen aufzubauen. Erst die erfindungsgemässen Ideen zeigen, wie diese zu realisieren sind.

"Bird-Cage"-Resonatoren bringen grosse Vorteile. Sie erzeugen ein sehr homogenes HF-Feld und können zudem als Quadraturdetektoren geschaltet werden, d.h. als Detektoren, die auf den Empfang von Drehfeldern optimiert sind. Für NMR-Messungen ist diese Detektionsmethode besonders vorteilhaft, weil das von den Atomkernen gesendete NMR-Signal ebenfalls ein Drehfeld ist. Ein Quadraturdetektor ist deshalb besser an das zu empfangende NMR-Signal angepasst und liefert daher ein S/N-Verhältnis, das im Idealfall um den Faktor $\sqrt{2}$ grösser sein kann, als bei einer konventionellen Detektion. Weitere Erklärungen über den Drehfeld-Detektor werden unten folgen.

Zusammenfassend gilt:

Der erfindungsgemässe Resonator ist ein "Bird-Cage"-Resonator in Hybrid-Technologie (d.h. er besteht aus normal-leitenden und supraleitenden Elementen), der zwar empfindlichkeitsmässig dem Stand der Technik entspricht, hinsichtlich guter $B_0$-Homogenität, kurzen Abklingzeiten und kurzen HF-Pulsen jedoch dem Stand der Technik weit überlegen ist.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1a    eine räumliche Darstellung einer Ausführungsform des erfindungsgemäßen HF-Generators mit aufgeschnittener Abschirmung;

Fig. 1b    eine Draufsicht auf die Ausführungsform nach Fig. 1a von oben;

Fig. 2    eine Vergrößerung des gestrichelten Bereichs aus Fig. 1b;

Fig. 3    eine Vergrößerung des gestrichelten Bereichs aus Fig. 2;

Fig. 4a    eine supraleitende Beschichtung einer supraleitenden Komponente, die parallel zum Magnetfeld $B_0$ ausgerichtet ist;

Fig. 4b    einen Schnitt durch die in Fig. 4a gestrichelt gezeichnete Ebene;

Fig. 5a    eine supraleitende Beschichtung, die senkrecht zum Magnetfeld $B_0$ orientiert ist;

Fig. 5b    einen Schnitt durch die Beschichtung aus Fig. 5a in der dort gestrichelt gezeichneten Ebene;

Fig. 6    einen schematischen Querschnitt durch eine supraleitende Komponente, die mittels Lot mit den Verbindungsringen verbunden ist.

Fig. 7    eine supraleitende Komponente, die über ein elektrisch isolierendes Blättchen kapazitiv mit den Verbindungsringen gekoppelt ist;

Fig. 8a    einen Querschnitt durch eine supraleitende Komponente mit durchgehender supraleitender Beschichtung parallel zum Magnetfeld $B_0$;

Fig. 8b    wie Fig. 8a, aber mit in parallele Streifen aufgetrennter supraleitender Beschichtung;

Fig. 9a    eine Ausführungsform des HF-Resonators mit schematisch dargestellter kapazitiver Signalauskopplung;

Fig. 9b    die Ausführungsform nach Fig. 9a von oben;

Fig. 10    eine Ausführungsform mit galvanischer Auskopplung schematisch von oben;

Fig. 11a    eine Ausführungsform mit induktiver Auskopplung;

Fig. 11b    die Ausführungsform nach Fig. 11a schematisch von oben;

Fig. 12    einen HF-Resonator mit zwei gegenüberliegenden supraleitenden Komponenten schematisch in Richtung der Längsachse (parallel zum Magnetfeld $B_0$);

Fig. 13    wie Fig. 12, aber mit vier supraleitenden Komponenten in punktsymmetrischer Verteilung;

Fig. 13a    wie Fig. 13, aber in axialsymmetrischer Verteilung;

Fig. 14    wie Fig. 12, aber mit sechs supraleitenden Komponenten in punktsymmetrischer Verteilung;

Fig. 14a    wie Fig. 14, aber in axialsymmetrischer Verteilung der sechs supraleitenden Komponenten;

Fig. 15    wie Fig. 12, aber mit acht supraleitenden Komponenten in punktsymmetrischer Verteilung;

Fig. 16a    einen HF-Resonator nach dem Stand der Technik;

Fig. 16b    den HF-Resonator nach Fig. 16a schematisch von oben;

Fig. 17a    einen HF-Resonator nach dem Stand der Technik gemäß US 5, 585, 723;

Fig. 17b    den HF-Resonator nach Fig. 17a schematisch von oben;

Fig. 18    eine elektrische Verschaltung zur Auskopplung von Signalen in Quadratur aus einem erfindungsgemäßen HF-Resonator in "Bird-Cage"-Ausführung;

Fig. 19    ein elektrisches Schaltbild eines Differentialübertragers nach dem Stand der Technik (Meinke/Gundlach);

Fig. 20a    zwei galvanisch voneinander getrennte kapazitiv gekoppelte supraleitende Beschichtungen;

Fig. 20b    wie Fig. 20a, aber mit in feine Streifen aufgeteilter supraleitender Beschichtung.

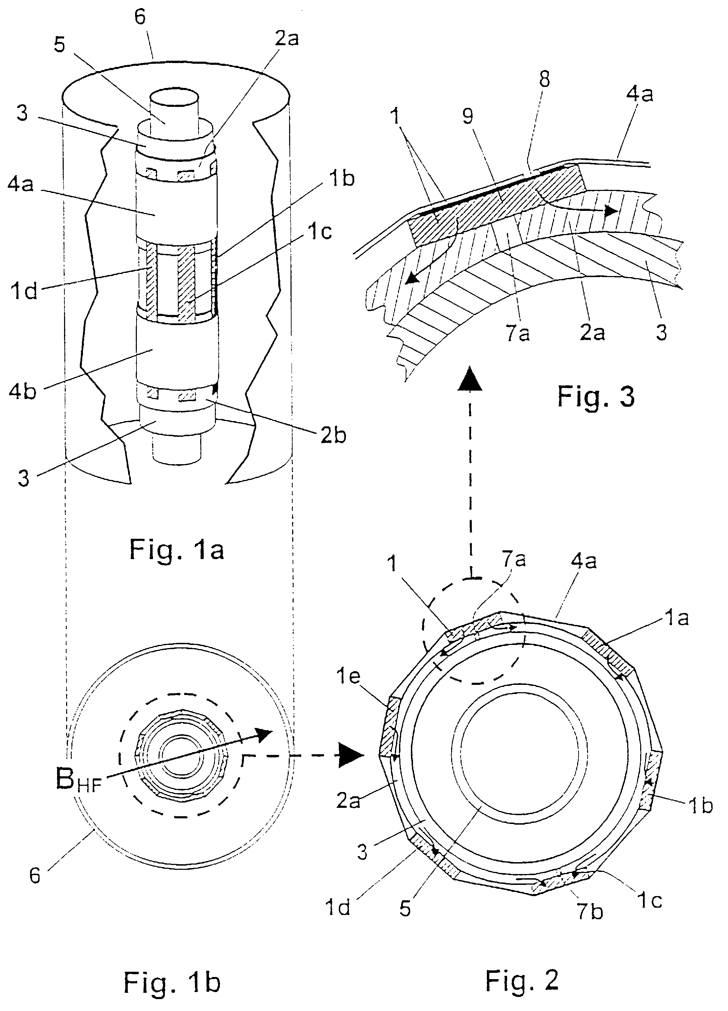

Fign. 1a und 1b zeigen eine Ausführungsform des erfindungsgemässen Resonators. Die notwendigen thermischen Isolationen aussen um den Resonator herum und innen zwischen einer Messprobe 5 und einem Trägergläschen 3 sind nicht explizit eingezeichnet. Sie können beispielsweise aus koaxialen Glasröhrchen bestehen, deren Zwischenräume abgeschlossen und evakuiert sind.

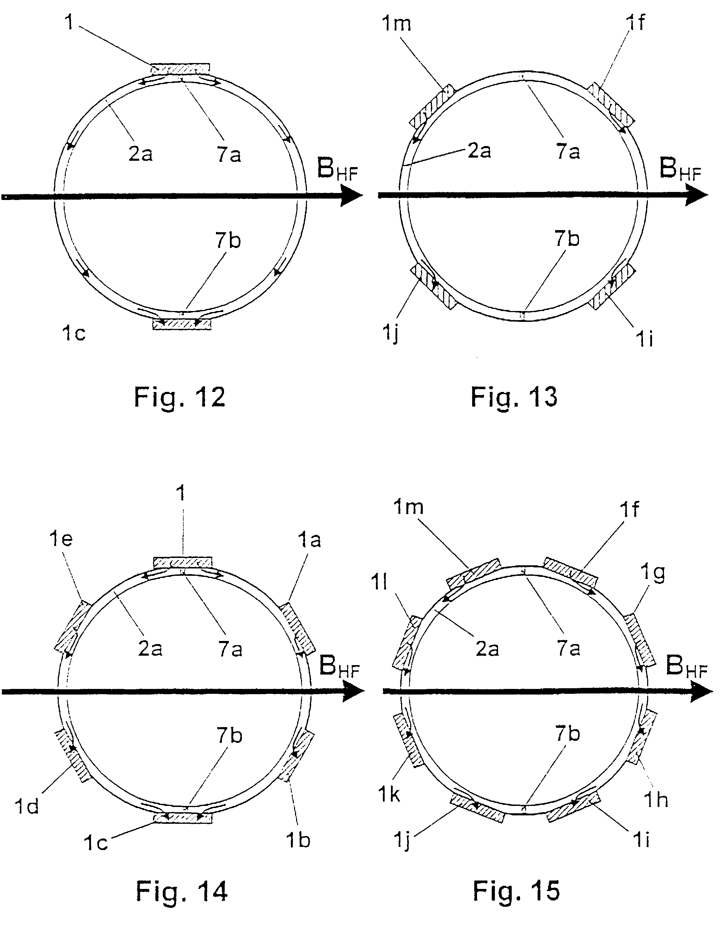

Die nachfolgend aufgeführten Werte für die Abmessungen des Resonators beziehen sich auf einen Resonator, der für eine zylindrische Messprobe mit einem Durchmesser von 5 mm gebaut ist. Für andere Messproben würden sich entsprechend andere Werte ergeben. Die supraleitenden Komponenten 1, 1a, 1b bis 1f stellen die parallel zum $H_0$-Feld liegenden Hauptanteile des Resonators dar. Diese setzen sich aus den in Fig. 3 im Querschnitt dargestellten langen, schmalen Kristallplättchen 9 zusammen (z.B. ca. 4 mm breit, ca. 45 mm lang und ca. 0.5 mm dick), auf deren Aussenseite die supraleitende Beschichtung 8 (ca. 0.5 µm Dicke) aufgetragen ist. Dargestellt ist in Fig. 2 eine Sechseranordnung, es können aber auch mehr oder auch weniger Plättchen verwendet werden, die auf einer zylinderförmigen, koaxial zur Messprobe liegenden Oberfläche angeordnet sind (siehe Fig. 12, Fig. 13 und Fig. 15).

Die supraleitenden Komponenten 1, 1a bis 1e liegen auf den zwei Verbindungsringen 2a und 2b (z.B. 10 mm Durchmesser und 15 mm Breite), die aus einem metallischen, elektrisch gut leitenden Material hergestellt sind (z.B. 20 µm dicke Folien aus Kupfer, Aluminium oder Silber), und um das Trägergläschen 3 gelegt werden. Die supraleitenden Komponenten werden mit den beiden Anpressvorrichtungen 4a und 4b auf die beiden ringförmigen Verbindungselemnte 2a und 2b gepresst, wodurch auch die beiden Verbindungsringe einen mechanischen Halt bekommen. Die Anpressvorrichtungen 4a, 4b sind beispielsweise Teflonbänder, die satt um die supraleitenden Komponenten 1 bis 1e gewickelt werden. Benachbarte Flächen zwischen den supraleitenden Schichten und den beiden Verbindungsringen stellen kapazitive Anteile des Resonators dar. Ihre Kapazitätswerte werden durch die Dielektrizitätskonstante der Kristallplättchen vorteilhaft erhöht.

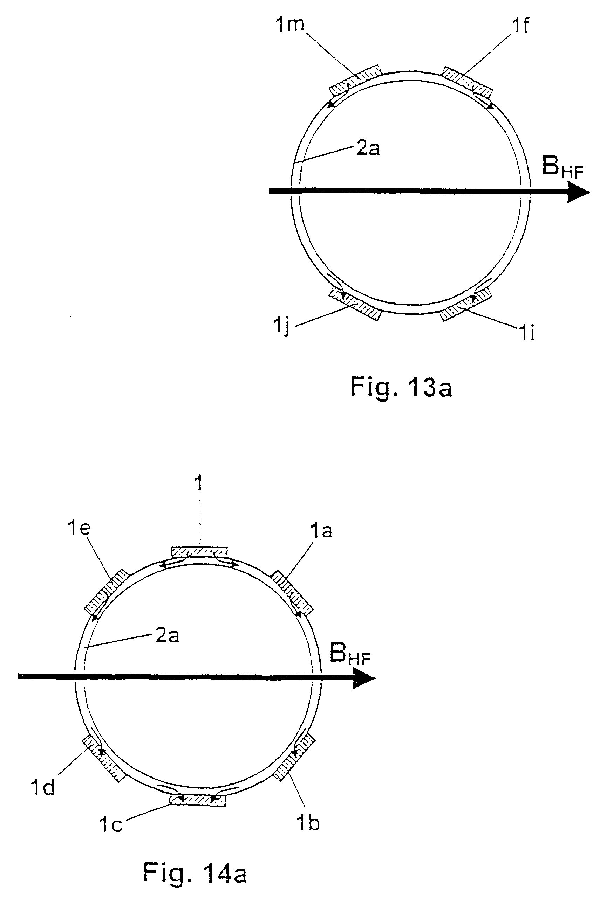

Um den gewünschten Schwingungs-Mode im Resonator zu unterstützen, sind die beiden Verbindungsringe an zwei zueinander diametral liegenden Stellen parallel zur Achse unterbrochen (Unterbrechungskanäle 7a und 7b). Dadurch wird ein vordefinierter Verlauf des HF-Stromflusses erzwungen, der in Fig. 2 mit Pfeilen dargestellt ist, und das hat zur Folge, dass die Vorrichtung zum Auskoppeln des NMR-Signals aus dem Resonator an einer wohldefinierten Stelle angebracht werden kann. Wenn die Anzahl der supraleitenden Komponenten gleich 2m ist, dann liegen die beiden Unterbrechungskanäle 7a und 7b bei einem ungeraden Wert von m unterhalb der Mitte einer supraleitenden Komponente (siehe Fig. 14), bei einem geraden Wert von m in der Mitte zwischen zwei supraleitenden Komponenten (siehe Fig. 15). Die Unterbrechungskanäle 7a und 7b haben einen weiteren Vorteil. Sie verkleinern die Wirbelströme in den Verbindungsringen 2a und 2b, die beim Schalten der z-Gradiente entstehen können.

Um die beschriebene Anordnung herum ist eine HF-Abschirmung 6 angebracht, die normalerweise zylinderförmig ist und elektrisch gut leitend sein muss, damit nicht zu grosse HF-Verluste in den Resonator transformiert werden. Sie kann aus einem normal leitenden Material, z.B. ein versilbertes Kupferrohr, oder noch besser aus einem Supraleiter bestehen.

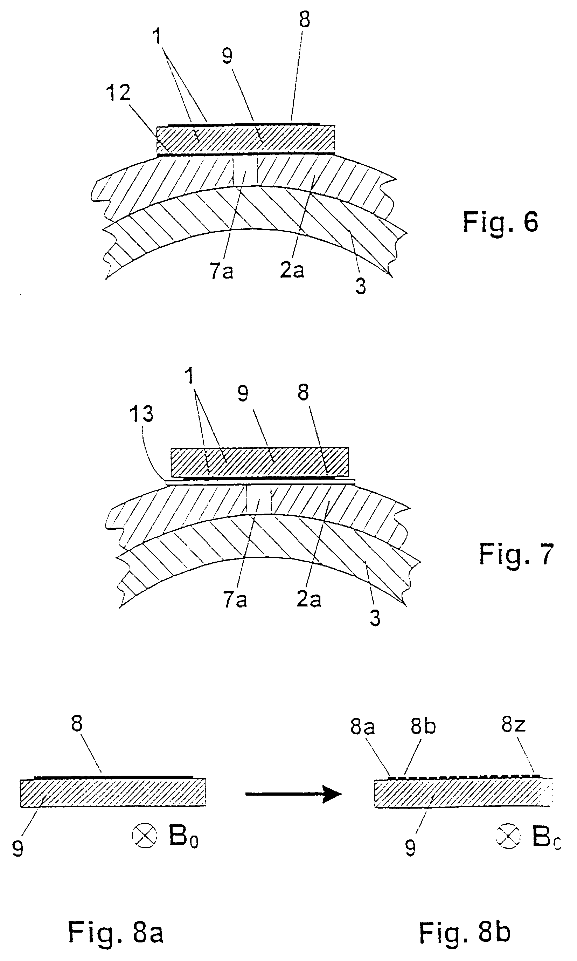

Die Verbindung der supraleitenden Komponenten 1, 1a bis 1e mit den Verbindungsringen 2a und 2b kann auch mit Hilfe eines suszeptibilitätsarmen Lots erfolgen, wie dies in Fig. 6 dargestellt ist. Dazu wird die Unterseite der supraleitenden Komponenten, und zwar nur an den Stellen, wo diese mit den Verbindungsringen in Berührung kommt, mit einem Metall (z.B. Kupfer) beschichtet (Metallschicht 12), und anschliessend die supraleitenden Komponenten an die Verbindungsringe gelötet.

Eine weitere Möglichkeit der Befestigung der supraleitenden Komponenten ist in Fig. 7 dargestellt. Die supraleitenden Komponenten werden umgekehrt montiert, d.h. mit der supraleitenden Schicht 8 nach innen, und zwischen den supraleitenden Komponenten und den Verbindungsringen werden dünne, elektrisch isolierende Plättchen 13 gelegt, die als Dielektrikum für die kapazitiven Anteile des Resonators dienen. Eine solche Scheibe darf nur sehr geringe dielektrische Verluste im HF-Bereich besitzen und kann aus einem Kunststoff (z.B. einem Teflon-Kompound) bestehen, oder noch besser aus einer dünnen keramischen Scheibe (z.B. $Al_2O_3$) mit einer geeignet hohen Dielektrizitätskonstanten (z.B. 9.8). Zur Befestigung dieser Teile werden wiederum die Anpressvorrichtungen 4a und 4b verwendet.

Die in den Figuren 12, 13, 14 und 15 dargestellten Anordnungen der supraleitenden Komponenten 1, 1a, 1b, ... 1m besitzen eine Punktsymmetrie. Diese Anordnungen erzeugen nur dann ein optimal homogenes HF-Feld innerhalb des umschlossenen Volumens, wenn genügend viele supraleitende Komponenten verwendet werden. Ist die Zahl dieser Komponenten jedoch niedrig, z.B. nur 4 oder 6, dann lässt sich die Homogenität des HF-Feldes innerhalb des umschlossenen Volumens durch symmetrisches Verschieben der einzelnen Komponenten verbessern. Aus der ursprünglichen Punktsymmetrie entsteht dadurch eine Axialsymmetrie, wie sie in Fig. 13a und 14a dargestellt ist. Einleuchtend ist diese Aussage, wenn die Zahl der Komponenten vier ist. In diesem Fall ist die Helmholtz-Anordnung, wie sie in Fig. 13a dargestellt ist, die optimalste, und nicht die punktsymmetrische Anordnung von Fig. 13. Fig. 14a zeigt die optimale Anordnung für den Fall von sechs supraleitenden Komponenten.

Bemerkenswert ist zudem, dass in diesen optimierten Anordnungen die Unterbrechungskanäle 7a und 7b nicht mehr notwendig sind, um eine bestimmte Stromverteilung zu erreichen. Die gewünschte Stromverteilung, die auch Schwingungs-Mode genannt wird, ergibt sich zwangsläufig durch die Axialsymmetrie (siehe Fig. 13a und 14a).

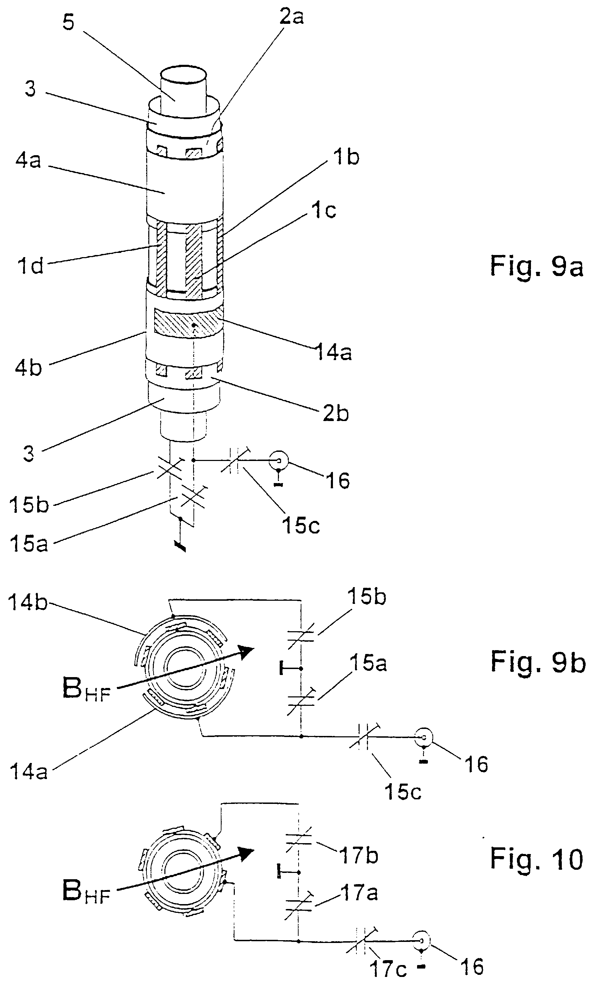

Die Figuren 9a, 9b, 10, 11a und 11b zeigen verschiedene Möglichkeiten, das NMR-Signal aus dem Resonator zu koppeln. Grundsätzlich gibt es deren drei, nämlich kapazitive, galvanische und induktive Auskopplungen.

Die kapazitive Auskopplung ist in Fig. 9a und Fig. 9b dargestellt. Mit den beiden Unterbrechungskanälen 7a und 7b ist die Richtung des HF-Feldes $B_{HF}$ des Resonators festgelegt, nämlich senkrecht zur Ebene, die durch die beiden Unterbrechungskanäle verläuft. Zwei metallische Folien 14a und 14b (z.B. aus Kupfer, Aluminium oder Silber) werden elektrisch isolierend über der Anpressvorrichtung 4b und den beiden Unterbrechungskanälen befestigt. Sie stellen zwei Koppelkapazitäten dar, die zwischen den Folien und den supraleitenden Komponenten wirken. Da der Resonator eine elektrisch symmetrische Anordnung darstellt, wird ein kapazitives Ankopplungsnetzwerk 15a, 15b und 15c ebenfalls symmetrisch aufgebaut. Die Weiterleitung des NMR-Signals erfolgt über eine niederohmige Koaxialleitung 16 von beispielsweise 50 Ohm. Damit die Symmetriebedingung des Ankopplungsnetzwerkes erfüllt ist, muss die Kapazität 15b ungefähr gleich der Summe der beiden Kapazitäten 15a und 15c sein. Mit dem Verhältnis der beiden Kapazitäten 15a und 15c lässt sich der Grad der Ankopplung an die Koaxialleitung 16 einstellen.

Fig. 10 stellt eine galvanische Auskopplung dar. Die Kontaktierungen befinden sich direkt auf den beiden supraleitenden Komponenten 1b und 1c, die symmetrisch zur Richtung des $B_{HF}$-Feldes liegen. Ein Auskopplungsnetzwerk 17a, 17b und 17c kann hier gleich wie bei der kapazitiven Auskopplung gewählt werden.

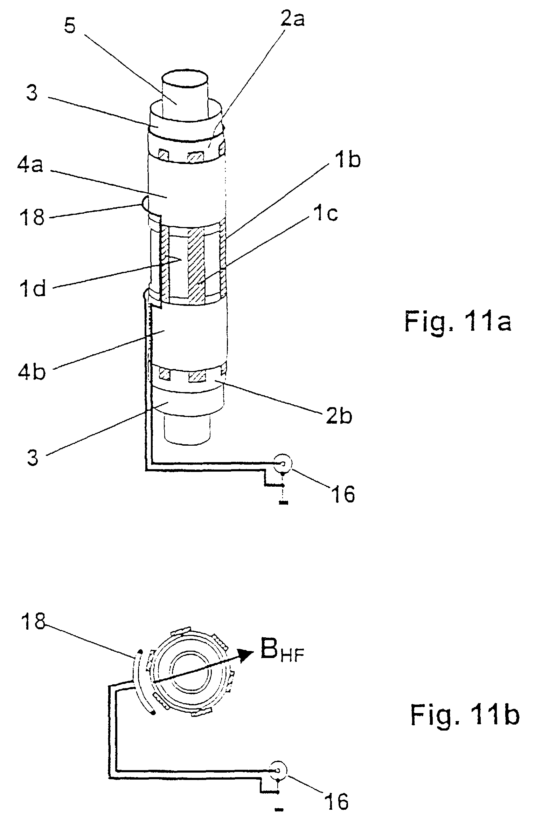

Fig. 11a und Fig. 11b zeigen eine induktive Auskopplung. Eine induktive Schleife 18 ist seitlich am Resonator angebracht, und zwar so, dass die Fläche der Schleife senkrecht zur Richtung des $B_{HF}$-Feldes steht. Durch Verschieben und Drehen der Schlaufe lässt sich die Ankopplung an den Resonator verändern. Die Resonanzfrequenz des Resonators muss mit zusätzlichen Mitteln, die hier nicht gezeigt sind, eingestellt werden. Das kann z.B. ein zylindrischer, metallischer Ring sein, der im Bereich der Verbindungsringe 2a und 2b über der Anpressvorrichtung 4a liegt und axial verschoben werden kann. Dadurch wird eine veränderliche kapazitive Belastung des Resonators erzeugt, mit der die Resonanzfrequenz eingestellt werden kann.

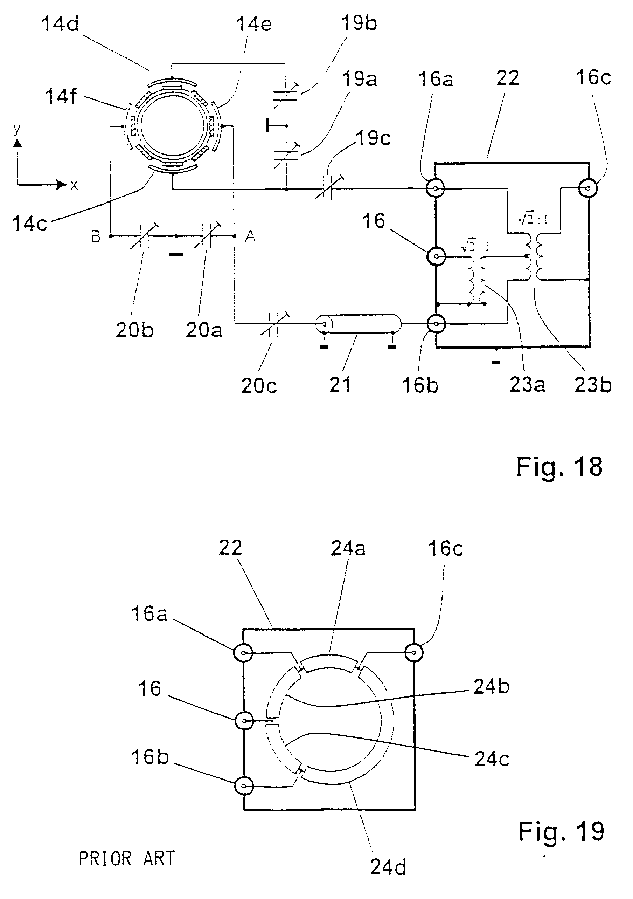

Wie schon weiter vorne erwähnt, kann der "Bird-Cage"-Resonator auch als Quadraturdetektor für den Empfang von Drehfeldern benützt werden. Diese Möglichkeit ergibt sich dank seines symmetrischen Aufbaus, mit dem zwei zueinander senkrecht stehende, identische Auskopplungen 14c und 14d sowie 14e und 14f möglich sind (siehe Fig. 18), die elektrisch und magnetisch voneinander entkoppelt sind. Das NMR-Drehfeld dreht in der xy-Ebene und erzeugt an den beiden kapazitiven Auskopplungen zwei NMR-Signale, die zeitlich um 90° zueinander verschoben sind. Diese beiden NMR-Signale werden mit Hilfe der Kapazitäten 19a, 19b und 19c sowie 20a, 20b, und 20c auf 50 Ohm impedanzmässig hinunter transformiert und anschliessend an die HF-Buchsen 16a und 16b eines Power-Splitter/-Combiners 22 geführt, wo die beiden NMR-Signale addiert und an die Ausgangsbuchse 16 geleitet werden. Die Ausgangsbuchse ist ihrerseits mit dem Vorverstärker (nicht dargestellt) verbunden.

Wie bereits erwähnt, sind die beiden NMR-Signale um 90° zueinander phasenverschoben. Um bei der Addition die volle Leistung der beiden NMR-Signale zu nützen, müssen sie in Phase addiert werden, d.h. eines dieser Signale muss noch eine zusätzliche Phasenverschiebung von 90° erfahren, was mit Hilfe der $\lambda$/4-Leitung 21 erreicht wird. Im weiteren ist zu beachten, dass die beiden NMR-Signale an den HF-Buchsen 16a und 16b je nach Drehrichtung des NMR-Drehfeldes entweder in Phase oder in Gegenphase sein können. Im Fall der Gegenphase würden sich die beiden Signale total kompensieren, was natürlich verhindert werden muss. Tritt dieser Fall ein, dann muss die Kapazität 20c mit dem Punkt B und nicht mehr mit dem Punkt A verbunden werden.

Mit dieser Quadraturdetektion kann die doppelte Signalleistung aus dem Resonator gekoppelt werden, was ein um den Faktor $\sqrt{2}$ höheres S/N-Verhältnis bedeutet!

Der Power-Splitter/-Combiner 22 setzt sich aus den beiden idealen Transformatoren 23a und 23b zusammen und stellt im wesentlichen eine symmetrische Brückenschaltung dar, die erstens das Sendesignal an der Eingangsbuchse 16c vom NMR-Signal an der Ausgangsbuchse 16 vollständig entkoppelt, zweitens die Leistungen der beiden NMR-Signale an den Buchsen 16a und 16b verlustlos addiert und an den Ausgang 16 führt, und drittens die zur Verfügung stehende Sendeleistung an der Buchse 16c verlustlos und gleichmässig auf die beiden Buchsen 16a und 16b, die über das kapazitive Neztwerk mit dem Resonator verbunden sind, verteilt. Die idealen Transformatoren müssen durch praktisch realisierbare Schaltungen ersetzt werden. Im HF-Gebiet eignen sich dazu am besten Schaltungen, die mit HF-Leitungen aufgebaut sind, z.B. ringförmig angeordnete HF-Leitungen, sogenannte Ringleitungen. Im Standardwerk "Taschenbuch der Hochfrequenztechnik" von Meinke/ Gundlach, Kapitel "Parallelgeschaltete Leitungen und Ringleitungen", Abbildung 14.7, ist ein solcher Differentialübertrager mit einer Ringleitung beschrieben. Dieser ist auch in Fig. 19 nochmals dargestellt, und zwar so, dass ein direkter Vergleich mit der idealisierten Schaltung in Fig. 18 möglich ist. Die Ringleitung besteht aus drei $\lambda/4$-Leitungen 24a, 24b, 24c und einer $3\lambda/4$-Leitung 24d, wobei alle vier Leitungen einen gemeinsamen Wellenwiderstand besitzen, der um den Faktor $\sqrt{2}$ grösser ist (z.B. 71 Ohm) als der Wellenwiderstand der $\lambda/4$-Leitung 21 und der beiden Leitungen, die an die Buchsen 16 und 16c angeschlossen werden (z.B. 50 Ohm).

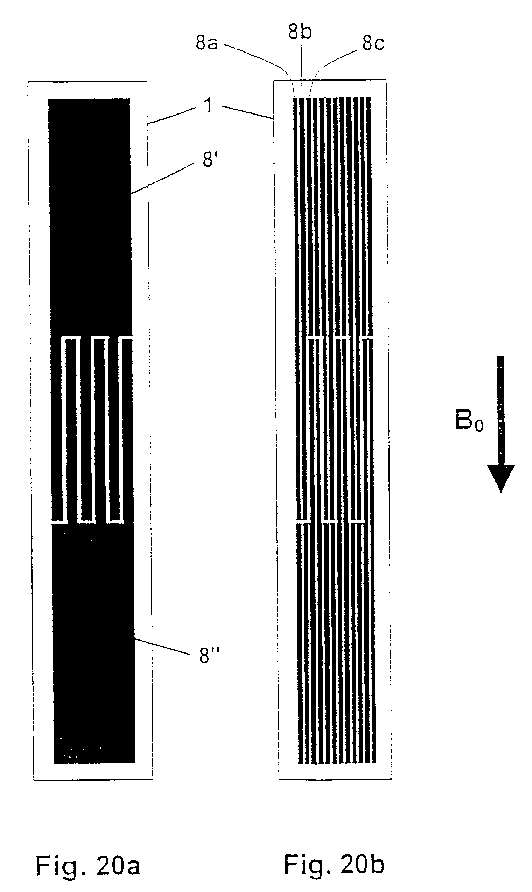

Bis jetzt wurden nur supraleitende Komponenten 1, 1a, 1b, ... beschrieben, die einzeln betrachtet galvanisch zusammenhängend und in feine Streifen 8a, 8b, 8c, ... eingeteilt waren. Der kapazitive Anteil des Resonators entstand an den Enden dieser supraleitenden Komponenten, dort wo diese mit den Verbindungsringen 2a und 2b in Berührung kamen. Das braucht aber nicht zwingend so zu sein, denn kapazitive Anteile können auch in die supraleitende Beschichtung 8 der supraleitenden Komponenten integriert werden, wie dies in den Fign. 20a und 20b dargestellt ist. Dadurch erübrigen sich die Kapazitäten zwischen den supraleitenden Komponenten und den Verbindungsringen und beide Teile können galvanisch miteinander verbunden werden. Die supraleitende Beschichtung kann z.B. aus zwei galvanisch voneinander getrennten Teilen 8' und 8" bestehen, die beide fingerförmig ineinander greifen und dadurch eine kapazitive Verbindung erzeugen. Fig. 20a zeigt eine mögliche Anordnung. Elektrisch gesehen stellen die beiden Teile 8' und 8" zwei Induktivitäten dar, die über eine Kapazität miteinander verbunden sind. Die Enden der beiden Teile 8' und 8" sind galvanisch mit den Verbindungsringen 2a und 2b verbunden. An Stelle der galvanischen Verbindung ist auch eine kapazitive Verbindung möglich, wobei vorzugsweise die Kapazität dieser Verbindung grösser bis sehr viel grösser als die fingerförmige Kapazität sein sollte.

Fig. 20b zeigt eine mögliche Anordnung, wie auch in diesem Fall die beiden supraleitenden Beschichtungen 8' und 8" in feine Streifen 8a, 8b, 8c, ... aufgeteilt werden können, um die Magnetisierung des Supraleiters gering zu halten.

Es ist auch möglich, mehrere fingerförmige Kapazitäten auf der supraleitenden Beschichtung anzubringen, die alle elektrisch in Serie geschaltet sind.

Zum Schluss soll noch auf die störenden Einflüsse von supraleitenden Materialen eingegangen werden. Betrachtet man die supraleitende Beschichtung 8, dann fliessen in dieser nicht nur die gewünschten HF-Ströme, sondern auch Gleichströme, die infolge der Magnetisierung des Supraleiters durch das statische $B_0$-Feld auftreten. Die supraleitende Schicht kann dadurch, abhängig von ihrer Masse und ihrer geometrischen Form und Orientierung, die Homogenität des Magnetfeldes stark verschlechtern. Es müssen deshalb bestimmte Regeln beachtet werden, die in den nachfolgenden 5 Punkten zusammengestellt sind. Wenn dort von Strömen die Rede ist, dann sind damit Gleichströme gemeint, die infolge der Magnetisierung des Supraleiters entstehen.

1) Die supraleitende Beschichtung sollte möglichst dünn sein, da ihr Einfluss auf die Homogenität des $B_0$-Feldes mit zunehmender Masse zunimmt. Die Beschichtung sollte aber doch noch so dick sein, dass die auftretenden HF-Ströme ungehindert fliessen können. Im allgemeinen genügt aber bereits eine Dicke von ca. 0.5 $\mu$m.

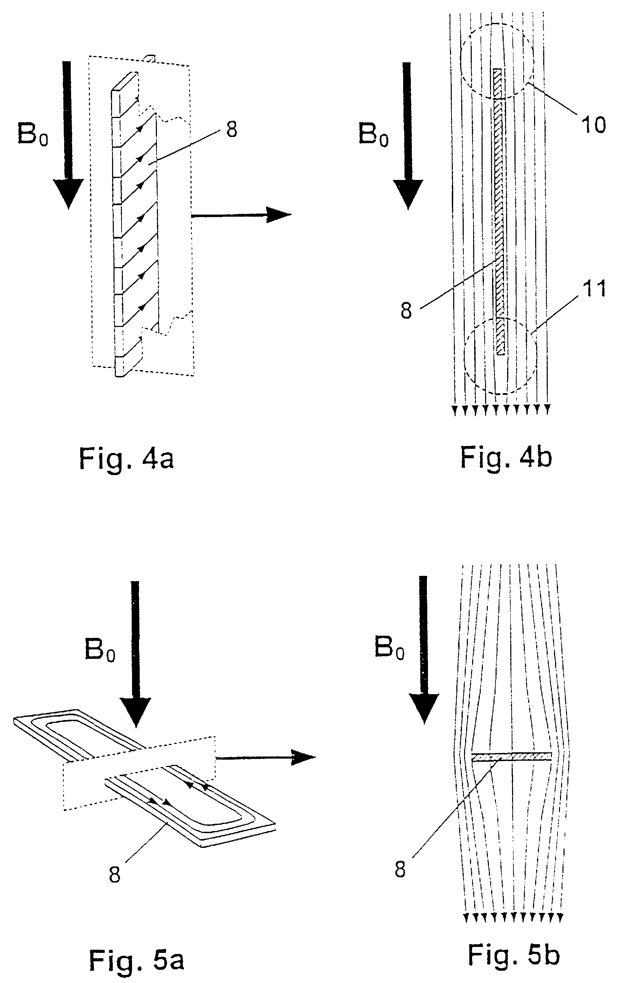

2) Die supraleitende Beschichtung 8 sollte möglichst parallel zum Feld $B_0$ des NMR-Magneten liegen, denn so hat sie den kleinsten Einfluss auf die Homogenität des $B_0$-Feldes am Ort der Messprobe 5. Dies ist in den Fign. 4a und 4b sowie in den Fign. 5a und 5b illustriert. In Fig. 4b ist eine supraleitende Beschichtung 8 dargestellt, die parallel zum $H_0$-Feld orientiert ist und praktisch keine Feldinhomogenitäten erzeugt. Liegt hingegen die supraleitende Beschichtung quer zum $H_0$-Feld, wie dies in Fig. 5b illustriert ist, dann werden starke Feldinhomogenitäten erzeugt.

3) Ist Punkt 2 erfüllt, dann sind es die in der Längsrichtung liegenden Enden 10, 11 der supraleitenden Beschichtung 8, welche noch Feldinhomogenitäten des $H_0$-Feldes erzeugen, und deshalb sollten diese möglichst weit entfernt vom aktiven Volumenbereich der Messprobe 5 liegen. Fig. 4b zeigt solche Inhomogenitäten an den Endteilen oben und unten, die aber nur sehr schwach in Erscheinung treten. In Fig. 1a lässt sich der aktive Volumenbereich der Messprobe 5 abschätzen. Er liegt zwischen den Verbindungsringen 2a und 2b des Resonators. Die Volumenbereiche der Messprobe 5, die im Innern der beiden Verbindungsringe 2a und 2b liegen, gehören nicht mehr dazu, denn die beiden Ringe haben einen abschirmenden Effekt auf die Messprobe 5 und verhindern, dass die Messprobe dort HF-mässig angeregt wird. In Fig. 1a erkennt man deutlich, dass die Enden der supraleitenden Komponenten 1b, 1c, 1d weit entfernt vom aktiven Volumenbereich der Messprobe 5 gelegt wurden.

4) Die Forderung unter Punkt 2 kann in der Praxis nie exakt erfüllt werden. Es muss immer mit einer gewissen kleinen Schrägstellung der supraleitenden Beschichtung 8 gegenüber dem $H_0$-Feld gerechnet werden. Dadurch entstehen grossflächige Kreisströme entlang den vier Seiten der Beschichtung, die unerwünschte Feldinhomogenitäten am Ort der Messprobe erzeugen können.

Um diesen Effekt abzuschwächen, wird die supraleitende Beschichtung 8 in möglichst viele einzelne, voneinander getrennte Streifen 8a, 8b, ... , 8z parallel zum Feld $H_0$ aufgeteilt (siehe Fign. 8a und 8b). Die Kreisströme werden dadurch gezwungen, sich innerhalb der schmalen Streifen kurzzuschliessen und haben deshalb einen viel geringeren Einfluss auf die Homogenität des $H_0$-Feldes.

5) Da die supraleitende Beschichtung 8 nicht aus einem ideal homogenen Material besteht, sind darin Bereiche mit unterschiedlichen kritischen Strömen vorhanden. Diese führen zu einer inhomogenen Verteilung der Stromfäden auf dem Supraleiter, und diese wiederum erzeugen Feldgradienten am Ort der Messprobe und verschlechtern dort die Homogenität des $H_0$-Feldes. Auch dieser Störeffekt kann durch eine Aufteilung in viele einzelne Streifen, wie dies unter Punkt 4 bereits beschrieben wurde, stark unterdrückt werden.

6) In der hochauflösenden NMR-Spektroskopie werden sogenannte Shim-Spulen verwendet, die aus unterschiedlichen Spulenanordnungen aufgebaut und mit Strömen durchflossen sind, die einzeln eingestellt werden können. Diese Shim-Spulen erzeugen zusätzliche Magnetfelder, mit denen eine Homogenisierung des $H_0$-Feldes erreicht wird. Die zusätzlichen Magnetfelder müssen nicht parallel zur supraleitenden Beschichtung 8 gerichtet sein, sondern können auch senkrecht zu ihr liegen. Dadurch erzeugen sie auf dieser Schicht relativ grossflächige Kreisströme, die starke Inhomogenitäten am Ort der Messprobe verursachen. Durch die Unterteilung des Supraleiters in viele feine Streifen, wie dies unter Punkt 3 bereits beschrieben wurde, kann auch in diesem Fall das Problem stark entschärft werden, denn auf diese Weise können nur kleinflächige Kreisströme mit reduzierten Stromstärken entstehen. Diese haben aber einen wesentlich kleineren Einfluss auf die Homogenität des $H_0$-Feldes.

**Patentansprüche**

1. Hochfrequenz(HF)-Resonator zum resonanten Aussenden und/ oder Empfangen von HF-Signalen auf einer gewünschten Resonanzfrequenz in eine bzw. aus einer Meßprobe (5) in einem Untersuchungsvolumen im homogenen Magnetfeld $B_0$ einer Kernspinresonanz(NMR)-Apparatur, wobei der HF-Resonator supraleitende Komponenten umfasst,
dadurch gekennzeichnet,
dass der HF-Resonator mindestens zwei, räumlich voneinander getrennte, im Betriebszustand supraleitende Komponenten (1, 1a, 1b...1m) aufweist, die weder einzeln für sich genommen noch zusammen ein geschlossenes Resonanzsystem bilden, das auf der gewünschten Resonanzfrequenz resonant schwingen kann, dass im Betriebszustand normalleitende Verbindungselemente (2a, 2b) vorgesehen sind, die die supraleitenden Komponenten (1, 1a... 1m) galvanisch oder kapazitiv derart miteinander verbinden, dass die supraleitenden Komponenten (1, 1a...1m) zusammen mit den normal-leitenden Verbindungselementen (2a, 2b) und zusätzlichen Mitteln zum Einstellen der Resonanzfrequenz ein oder mehrere geschlossene, auf der gewünschten Resonanzfrequenz resonant schwingungsfähige Resonanzsysteme bilden, und dass die supraleitenden Komponenten (1, 1a...1m) und die mit ihnen galvanisch oder kapazitiv verbundenen Verbindungselemente (2a, 2b) einen sogenannten "Bird-Cage"-Resonator mit Punktsymmetrie oder Axialsymmetrie bilden, wobei die supraleitenden Komponenten (1, 1a, ... 1m) die axialen Leiterteile und die normal-leitenden Verbindungselemente (2a, 2b) die ringförmigen Leiterteile der "Bird-Cage"-Struktur bilden.

2. HF-Resonator nach Anspruch 1, dadurch gekennzeichnet, dass die supraleitenden Komponenten (1, 1a,...1m) aus länglichen, schmalen und mit einer supraleitenden Beschichtung (8) versehenen Plättchen (9) bestehen, die jeweils parallel zum Magnetfeld $B_0$ orientiert und auf einem Zylindermantel, dessen Achse parallel zum Magnetfeld $B_0$ liegt und mit der Achse der Messprobe (5) übereinstimmt verteilt angeordnet sind.

3. HF-Resonator nach Anspruch 2, dadurch gekennzeichnet, dass die supraleitende Beschichtung (8) in möglichst viele feine Streifen (8a, 8b, 8c, ...) aufgeteilt ist, die alle parallel zum Magnetfeld $B_0$ orientiert sind.

4.  HF-Resonator nach Anspruch 2 oder 3, dadurch gekennzeichnet, dass die supraleitende Beschichtung (8) in mindestens zwei Bereiche (8' und 8") unterteilt ist, die miteinander kapazitiv verbunden sind.

5.  HF-Resonator nach einem der Ansprüch 2 bis 4, dadurch gekennzeichnet, dass die supraleitende Beschichtung (8) aus einem Hochtemperatur-Supraleiter, z.B. YBCO besteht.

6.  HF-Resonator nach einem der Ansprüch 2 bis 5, dadurch gekennzeichnet, dass die Plättchen (9) aus einem Kristall mit geeigneter kristalliner Struktur, z.B. $LaAlO_3$ oder Saphir bestehen.

7.  HF-Resonator nach einem der Ansprüch 2 bis 6, dadurch gekennzeichnet, dass die supraleitenden Komponenten (1, 1a,...1m) an ihren beiden axialen Enden kapazitiv oder galvanisch mit normal-leitenden, metallischen, ringförmigen Verbindungselementen (2a, 2b) mit hoher elektrischer Leitfähigkeit, verbunden sind.

8.  HF-Resonator nach Anspruch 7, dadurch gekennzeichnet, dass die Verbindungselemente (2a, 2b) an zwei diametral zueinander liegenden Stellen Unterbrechungskanäle (7a, 7b) aufweisen, die parallel zur Achse des Zylindermantels verlaufen, so dass eine vordefinierte Stromverteilung im Resonator entsteht.

9.  HF-Resonator nach Anspruch 8, dadurch gekennzeichnet, dass bei einer Anordnung mit 2·m supraleitenden Komponenten (1, 1a...1m) die Unterbrechungskanäle (7a, 7b) für m=ungerade in der Mitte unterhalb einer supraleitenden Komponente, und für m=gerade in der Mitte zwischen zwei benachbarten supraleitenden Komponenten liegen.

10. HF-Resonator nach einem der vorhergehenden Ansprüche, dadurch gekennzeichnet, dass die Auskopplung eines NMR-Signals aus dem "Bird-Cage"-Resonator über eine kapazitive Ankopplung (14a) erfolgt.

11. HF-Resonator nach einem der Ansprüche 1 bis 9, dadurch gekennzeichnet, dass die Auskopplung eines NMR-Signals aus dem "Bird-Cage"-Resonator über eine galvanische Ankopplung, vorzugsweise über direkte Kontaktierungen der supraleitenden Beschichtungen (8) erfolgt.

12. HF-Resonator nach einem der Ansprüche 10 oder 11, dadurch gekennzeichnet, dass der "Bird-Cage"-Resonator zwei orthogonal zueinander liegende Auskopplungen (14c, 14d und 14e, 14f) aufweist, mit denen eine Quadraturdetektion ermöglicht wird.

## Claims

1.  Radio-frequency (RF)-resonator for resonant transmission and/or reception of RF-signals at a desired resonance frequency into or out of a sample (5) in an investigational volume within a homogeneous magnetic field $B_0$ of a nuclear magnetic resonance (NMR) apparatus, wherein the RF-resonator comprises superconducting components,
    characterized in that
    the RF-resonator has at least two spatially separated superconducting components (1, 1a, 1b, ..., 1m) which do not form, either individually or collectively, a closed resonance system capable of resonating at the desired resonance frequency, that connection elements (2a, 2b) which are normal conducting under operating conditions, are provided to conductively and/or capacitively couple together the superconducting components (1, 1a, ..., 1m) in such a fashion that the superconducting components (1, 1a, ..., 1m), together with the normal conducting connection elements (2a, 2b) and additional means for setting the resonance frequency, form one or more closed resonance systems capable of resonating at the desired resonance frequency, and that the superconducting components (1, 1a, ..., 1m) and the connection elements (2a, 2b) which are conductively and/or capacitively connected thereto form a so-called "Bird Cage" resonator with point symmetry or axial symmetry, wherein the superconducting components (1, 1a, ... 1m) form the axial conducting components and the normal conducting connection elements (2a, 2b) form the ring-shaped conducting components of the "Bird Cage" structure.

2.  RF-resonator according to claim 1, characterized in that the superconducting components (1, 1a, ..., 1m) consist essentially of elongated narrow plates (9) having a superconducting layer (8), which are each oriented parallel to the magnetic field $B_0$ and distributed about a cylinder, the axis of which is parallel to the magnetic field $B_0$ and which coincides with the axis of the sample (5).

3.  RF-resonator according to claim 2, characterized in that the superconducting layer (8) is subdivided into as many fine strips (8a, 8b, 8c, ...) as possible all of which are directed parallel to the magnetic field $B_0$.

4.  RF-resonator according to claim 2 or 3, characterized in that the superconducting layer (8) is subdivided into at least two regions (8' and 8'') which are capacitively coupled to each other.

5. RF-resonator according to any one of the claims 2 through 4, characterized in that the superconducting layer (8) consists essentially of a high temperature superconductor e.g. YBCO.

6. RF-resonator according to any one of the claims 2 through 5, characterized in that the plates (9) consist essentially of a crystal having a suitable crystal structure, e.g. $LaAlO_3$ or sapphire.

7. RF-resonator according to any one of the claims 2 through 6, characterized in that the superconducting components (1, 1a, ..., 1m) are capacitively or conductively connected at their two axial ends to normal conducting, metallic, ring-shaped connection elements (2a, 2b) having high electrical conductivity.

8. RF-resonator according to claim 7, characterized in that the connection elements (2a, 2b) have two diametrically opposed interruption channels (7a, 7b) which extend parallel to the axis of the cylinder to effect a predefined current distribution in the resonator.

9. RF-resonator according to claim 8, characterized in that, in a configuration having 2·m superconducting components (1, 1a, ..., 1m), the interruption channels (7a, 7b), for m = odd, are disposed in the middle below a superconducting component and, for m = even, in the middle between two neighbouring superconducting components.

10. RF-resonator according to any one of the preceding claims, characterized in that the coupling-out of an NMR-signal from the "Bird Cage" resonator is effected via capacitive coupling (14a).

11. RF-resonator according to any one of the claims 1 through 9, characterized in that the coupling-out of an NMR-signal from the "Bird Cage" resonator is effected via a conductive coupling, preferentially by a direct contacting of the superconducting layers (8).

12. RF-resonator according to any one of the claims 10 or 11, characterized in that the "Bird Cage" resonator has two mutually orthogonal out-couplings (14c, 14d and 14e, 14f) to facilitate quadrature detection.

## Revendications

1. Résonateur haute fréquence (HF) pour l'émission et/ou la réception résonante de signaux HF à une fréquence de résonance souhaitée dans ou à partir d'un échantillon de mesure (5) dans un volume d'analyse dans le champ magnétique homogène $B_0$ d'un appareil à résonance magnétique nucléaire (RMN), le résonateur HF comprenant des composants supraconducteurs, **caractérisé** en ce que le résonateur HF présente au moins deux composants (1, 1a, 1b ... 1m) supraconducteurs à l'état de service, spatialement séparés les uns des autres, qui ne constituent ni pris individuellement, ni ensemble un système résonant fermé pouvant osciller en résonance à la fréquence de résonance souhaitée, en ce qu'il est prévu des éléments de liaison (2a, 2b) normalement conducteurs à l'état de service, qui relient entre eux les composants supraconducteurs (1, 1a, ... 1m) de façon galvanique ou capacitive de telle sorte que les composants supraconducteurs (1, 1a, ... 1m) forment, conjointement avec les éléments de liaison normalement conducteurs (2a, 2b) et des moyens supplémentaires pour régler la fréquence de résonance, un ou plusieurs systèmes résonants fermés capables d'osciller en résonance à la fréquence de résonance souhaitée, et en ce que les composants supraconducteurs (1, 1a, ... 1m) et les éléments de liaison (2a, 2b), qui leur sont reliés de façon galvanique ou capacitive, forment un résonateur dit « en cage » (en anglais « birdcage resonator ») à symétrie ponctuelle ou axiale, les composants supraconducteurs (1, 1a, ... 1m) formant les parties conductrices axiales et les éléments de liaison normalement conducteurs (2a, 2b) les parties conductrices annulaires de la structure « en cage ».

2. Résonateur HF selon la revendication 1, **caractérisé** en ce que les composants supraconducteurs (1, 1a, ... 1m) consistent en des lamelles (9) étroites et oblongues, pourvues d'un revêtement supraconducteur (8), qui sont respectivement disposées en étant orientées parallèlement au champ magnétique $B_0$ et en étant réparties sur une surface cylindrique dont l'axe est parallèle au champ magnétique $B_0$ et coïncide avec l'axe de l'échantillon de mesure (5).

3. Résonateur HF selon la revendication 2, **caractérisé** en ce que le revêtement supraconducteur (8) est réparti en un nombre maximal de fines bandelettes (8a, 8b, 8c, ...) qui sont toutes orientées parallèlement au champ magnétique $B_0$.

4. Résonateur HF selon la revendication 2 ou 3, **caractérisé** en ce que le revêtement supraconducteur (8) est subdivisé en au moins deux zones (8' et 8''), qui sont reliées entre elles de façon capacitive.

5. Résonateur HF selon une des revendications 2 à 4, **caractérisé** en ce que le revêtement supraconducteur (8) est constitué d'un supraconducteur à haute température, YBCO par exemple.

6. Résonateur HF selon une des revendications 2 à 5, **caractérisé** en ce que les lamelles (9) sont constituées d'un cristal à structure cristalline appropriée, LaAlO$_3$ par exemple, ou de saphir.

7. Résonateur HF selon une des revendications 2 à 6, **caractérisé** en ce que les composants supraconducteurs (1, 1a, ... 1m) sont reliés à leurs deux extrémités axiales, de façon capacitive ou galvanique, à des éléments de liaison (2a, 2b) normalement conducteurs métalliques et annulaires, présentant une haute conductivité.

8. Résonateur HF selon la revendication 7, **caractérisé** en ce que les éléments de liaison (2a, 2b) présentent en deux points diamétralement opposés des canaux d'interruption (7a, 7b) qui s'étendent parallèlement à l'axe de la surface cylindrique, de sorte qu'on obtient une répartition prédéfinie du courant dans le résonateur.

9. Résonateur HF selon la revendication 8, **caractérisé** en ce que, pour un agencement avec 2 x m composants supraconducteurs (1, 1 a, ... 1m), les canaux d'interruption (7a, 7b) se trouvent, au milieu en dessous d'un composant supraconducteur si m est impair, et au milieu entre deux composants supraconducteurs voisins si m est pair.

10. Résonateur HF selon une des revendications précédentes, **caractérisé** en ce que le découplage d'un signal RMN provenant du résonateur « en cage » s'effectue au moyen d'un couplage capacitif (14a).

11. Résonateur HF selon une des revendications 1 à 9, **caractérisé** en ce que le découplage d'un signal RMN provenant du résonateur « en cage » s'effectue au moyen d'un couplage galvanique, de préférence au moyen de mises en contact directes des revêtements supraconducteurs (8).

12. Résonateur HF selon la revendication 10 ou 11, **caractérisé** en ce que le résonateur « en cage » présente deux découplages orthogonaux (14c, 14d et 14e, 14f), qui permettent une détection de quadrature.

Fig. 1a

Fig. 1b

Fig. 3

Fig. 2

$B_0$

8

Fig. 4a

$B_0$

10

8

11

Fig. 4b

$B_0$

8

Fig. 5a

$B_0$

8

Fig. 5b

Fig. 6

Fig. 7

Fig. 8a

Fig. 8b

Fig. 9a

Fig. 9b

Fig. 10

Fig. 11a

Fig. 11b

Fig. 12

Fig. 13

Fig. 14

Fig. 15

1m · · · · · · · · · · · · · · · · · · · · 1f

2a

$B_{HF}$

1j · · · · · · · · · · · · · · · · · · · · 1i

## Fig. 13a

1e · · · · · · · · 1 · · · · · · · · 1a

2a

$B_{HF}$

1d · · · · · · · · · · · · · · · · · · · · 1b

1c

## Fig. 14a

PRIOR ART

5

6

18a

18b

19b

20

21

Fig. 16a

Fig. 17a

5

6

5

18b

19a

18a

19b

19a

18a

Fig. 16b

Fig. 17b

**Fig. 18**

PRIOR ART

**Fig. 19**

21

Fig. 20a        Fig. 20b